# FASCICULE DE BREVET EUROPEEN

(11) **EP 1 581 033 B1**
(45) Date de publication et mention de la délivrance du brevet: **17.11.2010**
(21) Numéro de dépôt: 05101893.5
(22) Date de dépôt: 11.03.2005
(51) Int. Cl.: H05K 3/30, H01R 33/72

(54) **Plaquette métallique de connexion électrique, composant électrique comportant cette plaquette et adaptateur de connexion**
Metallplättchen zur elektrischen Verbindung, elektrisches Bauteil mit diesem Plättchen und Verbindungsadapter
Metallic platelet for electrical connection, electric component comprising this platelet and connection adapter

(30) Priorité: 25.03.2004 FR 0403107
(43) Date de publication de la demande: 28.09.2005
(73) Titulaire: DAV, 94000 Creteil (FR)
(72) Inventeur: Vanhell, Stephane, 74970, MARIGNIER (FR); Ducruet, Rene M., 74370, CRANVES-SALES (FR)
(74) Mandataire: Benoit, Monique

(56) Documents cités:
- JP-A- 6 085 146

## Description

La présente invention est relative à une plaquette métallique de connexion électrique, un composant électrique comportant cette plaquette et un adaptateur de connexion.

Dans la fabrication des modules électriques et/ou électroniques du type comportant des composants électriques et/ou électroniques montés sur une carte à circuit imprimé, on utilise de plus en plus des composants à montage en surface, couramment appelés composants CMS. A cet effet, les composants CMS, munis de pattes de connexion appropriées, sont posés sur des plages conductrices sur la surface d'une carte à circuit imprimé, qui ont été préalablement revêtues d'une pâte à braser par une technique de sérigraphie, puis on fait passer la carte à circuit imprimé portant les composants CMS dans un four de refusion afin de souder les pattes de connexion des composants CMS à leur plages conductrices respectives sur la carte à circuit imprimé.

L'utilisation de cette technique suppose que le composant a été développé exprès pour ce type de technique de soudage pour la connexion, en particulier qu'il dispose de pattes de connexion appropriées.

Or, il existe de multiples composants électriques qui ont été développés pour être fixés par d'autres techniques sur une carte à circuit imprimé, en particulier des circuits imprimés à double face.

Ainsi, il existe des composants électriques tels que des interrupteurs électriques dans l'automobile, qui présentent une ou plusieurs fiches de contact destinées à être fixées sur la carte à circuit imprimé. Traditionnellement, le procédé de soudage de ces interrupteurs nécessite le pré-positionnement de l'interrupteur sur la carte à circuit imprimé de façon que les fiches traversent la carte, le retournement de la carte pour effectuer le soudage des fiches et puis un dernier retournement de la carte à circuit imprimé.

Pour éviter l'utilisation des cartes à circuit imprimé double face qui sont plus chères que des cartes équivalentes simple face et pour éviter le double retournement de la carte à circuit imprimé lors du soudage de l'interrupteur, on souhaiterais appliquer à ces composants la technique de soudage par refusion.

Cependant, la simple application de la technique de soudage par refusion ne permet pas d'assurer une bonne connexion électrique de ces fiches pour les plages de courant requises, en particulier des courants forts de l'ordre de 30A.

Une autre problématique réside dans le fait que certains composants électriques ou électroniques n'ont pas une tenue en température suffisante pour pouvoir résister à la température régnant dans le four de refusion. C'est pourquoi, on utilise habituellement dans ce cas des connecteurs électriques, réalisés eux mêmes en tant que composants CMS, qui sont fixés sur la carte à circuit imprimé par la technique de brasage par refusion et auxquels sont ensuite connectés les composants électriques ou électroniques qui supportent mal la température du four de refusion. Ces connecteurs électriques sont usuellement constitués d'un boîtier en matière isolante et de pièces de contact électrique femelles disposées dans des alvéoles du boîtier.

Certains composants électroniques ou électriques, comme par exemple des petits moteurs pas à pas, ont des broches ou des languettes de connexion présentant un écart relativement important les unes par rapport aux autres. Il faut alors utiliser un connecteur dont le boîtier a un encombrement important par rapport aux pièces de contact qu'il contient.

JP 06085146 décrit un connecteur électrique permettant d'adapter un composant électrique à fiches de connexion, à un montage CMS.

La présente invention vise à pallier ces inconvénients en proposant une plaquette de connexion de faible encombrement permettant l'adaptation des composants électriques à fiches à un montage par soudage par refusion analogue à celui d'un composant CMS tout en permettant une soudure satisfaisante en particulier pour les applications courant fort.

A cet effet, l'invention a pour objet une plaquette métallique de connexion selon la revendication 1.

L'invention a également pour objet un composant électrique comportant au moins une fiche de connexion destinée à être connectée à ladite carte à circuit imprimé, caractérisé en ce qu'il comporte pour chaque fiche une plaquette tel que définie ci-dessus et intérgrée par surmoulage dans sa face destinée à être en vis-à-vis d'une carte à circuit imprimé.

L'invention a également pour objet un adaptateur de connexion permettant d'établir une connexion électrique entre un composant électrique et une carte à circuit imprimé, dans lequel le composant comporte au moins une fiche de connexion destinée à être connectée à ladite carte à circuit imprimé, caractérisé en ce qu'il comporte pour chaque fiche une plaquette tel que définie ci-dessus.

D'autres caractéristiques et avantages de l'invention ressortiront de la description suivante, donnée à titre d'exemple, sans caractère limitatif, en regard des dessins annexés sur lesquels :
- la figure 1 est une vue en perspective de la face inférieure de l'adaptateur selon l'invention,
- la figure 2 est une vue en perspective de la face supérieure de l'adaptateur selon l'invention, et
- la figure 3 est une vue en coupe selon l'axe I-I de la figure 1 de l'adaptateur selon l'invention montrant de plus un composant électrique à fiches monté sur un circuit imprimé à l'aide de cet adaptateur selon l'invention.

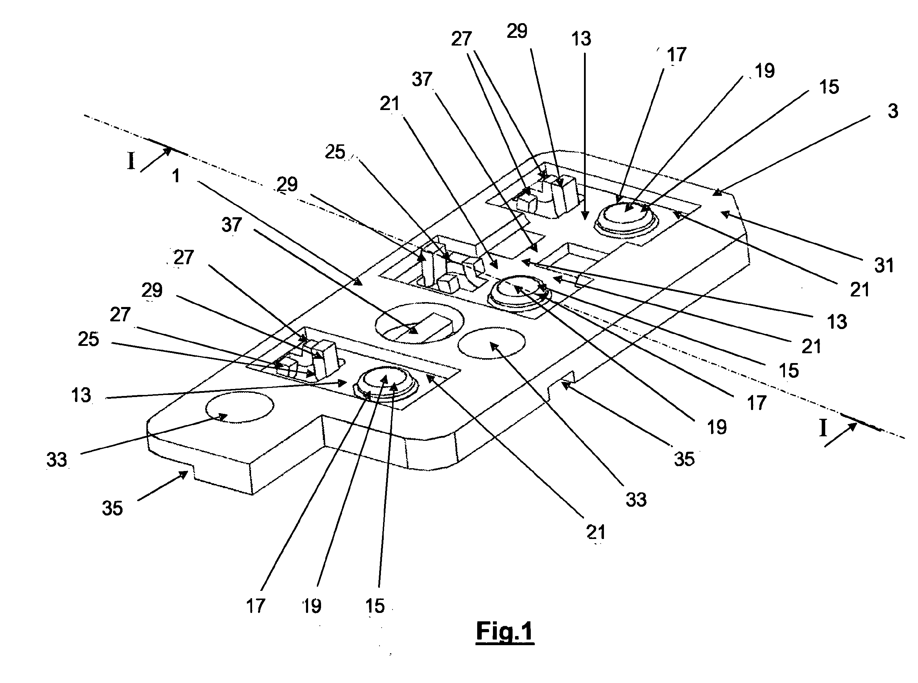

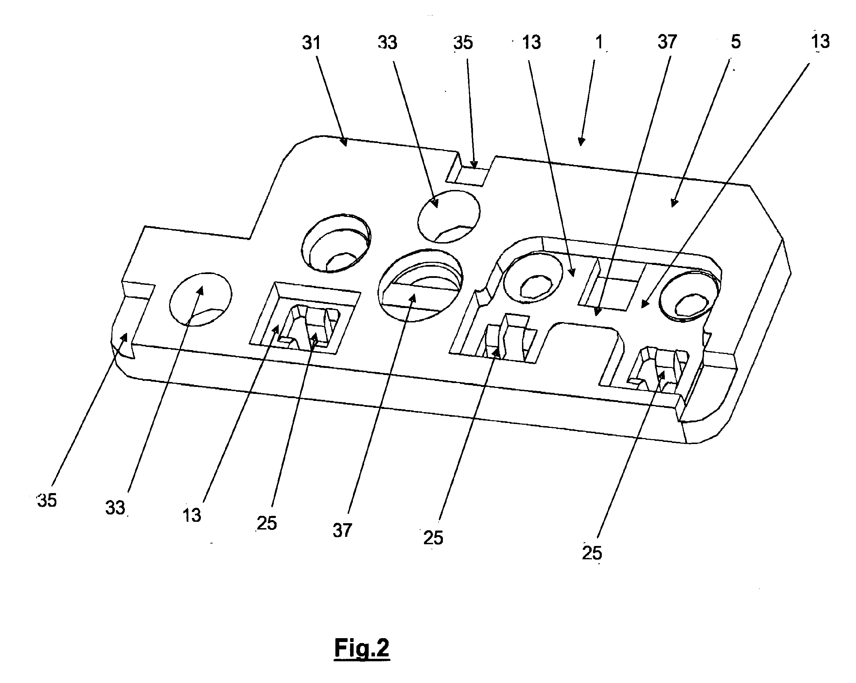

Un exemple de réalisation non limitatif de l'invention sera décrit par la suite en relation aux trois figures annexées. Sur la figure 1 est représentée en perspective la face inférieure 3 d'un adapteur 1 selon l'invention et sur la figure 2 la face supérieure 5 de l'adaptateur 1.

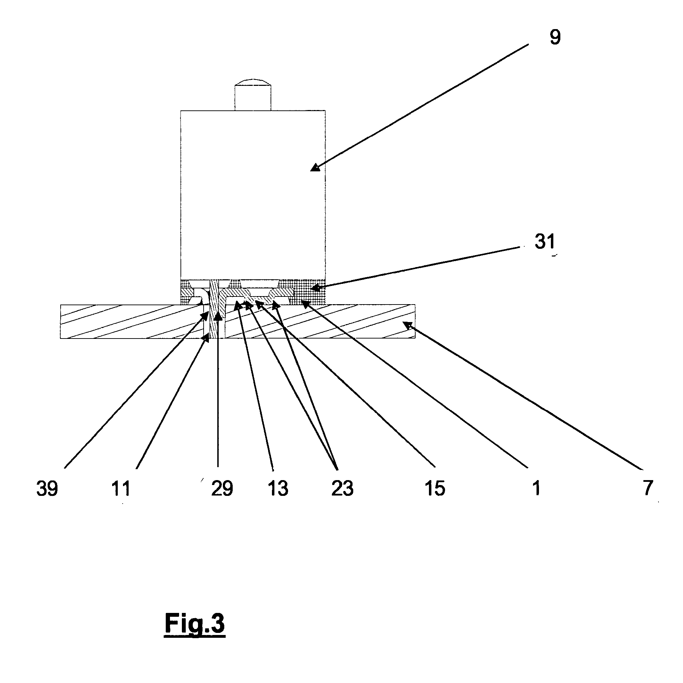

Par face inférieure, on comprend la face 3 de l'adaptateur 1 destinée à être en contact avec une carte à circuit imprimé 7 (voir figure 3), en particulier à simple face.

Par face supérieure, on comprend la face 5 de l'adaptateur 1 destinée à être en contact avec un composant électrique 9 (voir figure 3), tel qu'un interrupteur pour véhicule automobile, comportant au moins une ou plusieurs, et dans le présent exemple trois fiches 11 de connexion électrique dont une seule est visible sur la figure 3.

L'adapateur comprend trois plaquettes métalliques 13, c'est-à-dire une plaquette 13 pour chaque fiche de connexion 11 du composant 9. Ces plaquettes de connexion 13 permettent d'établir une connexion électrique entre le composant électrique 9 et la carte à circuit imprimé 7.

Comme on le voit sur les figures 1 à 3, chaque plaquette 13 possède une forme générale plane et rectangulaire de faible encombrement. A titre d'exemple, une telle plaquette présente une longueur de 5,6 mm, une largeur de 3,5 mm et une hauteur de 1,2 mm.

Une extrémité de la plaquette comporte une plage de connexion 15 destinée à être connectée par refusion à un contact associé de la carte à circuit imprimé 7.

Plus en détail, la plage de connexion par refusion possède un bossage 17 de préférence avec une partie centrale 19 plane, réalisé par exemple par poinçonnage et destiné à être en contact avec le circuit imprimé 9.

Avantageusement, des évidements de matières 21 sont ménagés autour de chaque plage de connexion 17 pour l'absorption du surplus de brasure lors du passage en four de refusion afin de favoriser la formation du ménisque de soudure 23 (voir figure 3).

L'autre extrémité de la plaquette 13 comporte un contact électrique par serrage 25 destiné de recevoir ladite fiche de connexion 11 pour établir par insertion de celle-ci un contact électrique avec le composant électrique 9.

Ce contact électrique par serrage 25 est formé par deux aillettes latérales 27 et une languette centrale 29 réalisés par poinçonnage et disposés en vis-à-vis à la façon d'un trépied.

Avantageusement, la languette centrale 29 présente une longueur supérieure à celle des ailettes latérales 27 et est inclinée en position de repos en direction des aillettes 27 pour pouvoir assurer un serrage mécanique de la fiche du composant électrique 9.

Au moins une, de préférence les deux ailettes latérales 27 présentent une longueur suffisante pour venir en contact avec le circuit imprimé 7 et la pâte à souder lors du montage sur circuit.

Comme présenté aux figures 1 et 2, les plaquettes de connexion 13 sont logées dans un support 31 non métallique, de préférence en plastique, réalisé en un matériau suceptible de résister sans déformation à la température d'un four de refusion.

En fonction de la composition de la pâte à braser, le support non métallique 31 est apte à résister à des températures inférieures à 250°C , voire 300°C par exemple si on souhaite utiliser des pâtes à braser sans plomb.

Comme plastique, on utilise des matériaux communément connu sous les noms de PCT ( polyester (cyclohexylène-dimethylene-terephtalate)), SPS (polystyrène syndiotactique) ou un polymer cristallin.

Pour assurer la bonne disposition du composant 9, de l'adaptateur 1 et de la carte à circuit imprimé, le support non métallique présente des premiers moyens de positionnement 33, par exemple des trous, aptes à coopérer avec des moyens complémentaires de la carte à circuit imprimé pour un positionnement exact de l'adaptateur sur la carte avant refusion et / ou des seconds moyens de positionnement 35, par exemple une découpe, aptes à coopérer avec des moyens complémentaires du composant électrique pour un positionnement exact du composant 9 sur l'adaptateur 1.

Comme représenté sur les figures 1 et 2, les plaquettes 13 d'un adaptateur 1 sont réliées par un pont seccable 37 avant installation sur le circuit imprimé et surmoulées lors de la fabrication du support. Avant montage sur le circuit, ces ponts 37 sont coupés par un outil.

Par la suite, on décrira le montage d'un adaptateur 1 et d'un composant électrique 9 sur une carte à circuit imprimé. On suppose, que les ponts seccables ont déjà été coupés.

On dépose donc de la pâte à braser, par exemple par sérigraphie, sur le circuit imprimé 7 aux endroits destinés à recevoir des plages de connexion 19 de l'adaptateur 1.

Puis, on dépose l'adaptateur 1 sur le circuit impimé 7 et on fait passer l'ensemble dans un four de refusion.

Enfin, on insère les fiches 11 du composant 9 dans les contacts électriques par serrage 25 associés, ce qui fixe aussi le composant sur le circuit imprimé 9.

En variante, dans le cas où le composant possède une tenue en température suffisante pour pouvoir résister à la température régnant dans le four de refusion, on préfère assembler tout d'abord l'adaptateur 1 et le composant électrique 9, puis de déposer de la pâte à braser non seulement aux endroits destinés à recevoir des plages de connexion 19 mais aussi autour du trou 39 (voir figure 3) de la carte à circuit imprimé 7 traversé par la fiche de connexion 11 ce qui permet de renforcer la liaison électrique en particulier pour des courants forts de l'ordre de 30A et de monter le composant 9 avec l'adaptateur 3 en une seule opération. On note par ailleurs que la longueur de la languette centrale 29 permet avantageusement d'assurer le drainage de la soudure vers le bas de la fiche 11.

Dans cette dernière variante, on a constaté que les ailettes 27 et la languette 29 favorisent de façon avantageuse la remontée par capillarité de la pâte à braser lors du processus de refusion.

Selon une variante avantageuse non représentée destinée également à un composant ayant une tenue en température suffisante, on prévoit que le composant électrique comporte pour chaque fiche une plaquette tel que décrite ci-dessus et intérgrée par surmoulage dans la face du composant destinée à être en vis-à-vis d'une carte à circuit imprimé. Cette variante permet qu'un composant standard à fiches de connexion puisse être adapté avec peu de frais à un montage analogue à celui d'un composant CMS.

## Revendications

1. Plaquette métallique (13) de connexion permettant d'établir une connexion électrique entre un composant électrique (9) et une carte à circuit imprimé (7), dans lequel le composant (9) comporte au moins une fiche de connexion (11) destinée à être connectée à ladite carte à circuit imprimé (7), **caractérisée en ce que** ladite plaquette (13) possède une forme générale plane présentant d'une part une plage (15) de connexion par refusion destinée à être connectée par refusion à un contact associé de la carte à circuit imprimé (7) et d'autre part un contact électrique (25) par serrage destiné de recevoir ladite fiche de connexion (11) pour établir par insertion de la fiche (11) un contact avec le composant électrique (9), ledit contact électrique par serrage (25) présentant deux ailettes latérales (27) et une languette centrale (29) réalisées par poinçonnage et disposées en vis-à-vis.

2. Plaquette selon la revendication 1, **caractérisée en ce que** la plage de connexion (15) par refusion présente un bossage (17) destiné à être en contact avec le circuit imprimé (7) et la pâte à souder.

3. Plaquette selon la revendication 2, **caractérisée en ce que** le bossage (17) présente une partie centrale plane (19).

4. Plaquette selon l'une des revendications 1 à 3, **caractérisée en ce que** des évidements de matières (21) sont ménagés autour de chaque plage de connexion (15) pour l'absorption du surplus de brasure afin de favoriser la formation du ménisque de soudure.

5. Plaquette selon l'une des revendications 1 à 4, **caractérisée en ce que** la languette centrale (29) présente une longueur supérieure à celle des ailettes latérales (27) et est inclinée en direction des ailettes (27) pour pouvoir assurer un serrage mécanique de la fiche (11) du composant électrique (9).

6. Plaquette selon l'une des revendications 1 à 5, **caractérisée en ce qu'**au moins une des ailettes latérales (27) présente une longueur suffisante pour venir en contact avec le circuit imprimé (7) et la pâte à souder.

7. Composant électrique comportant au moins une fiche de connexion (11) destinée à être connectée à ladite carte à circuit imprimé (7), **caractérisé en ce qu'**il comporte pour chaque fiche (11) une plaquette (13) selon l'une quelconque des revendications 1 à 6 intégrée par surmoulage dans sa face destinée à être en vis-à-vis d'une carte à circuit imprimé.

8. Adaptateur de connexion permettant d'établir une connexion électrique entre un composant électrique (9) et une carte à circuit imprimé (7), dans lequel le composant (9) comporte au moins une fiche de connexion (11) destinée à être connectée à ladite carte à circuit imprimé (7), **caractérisé en ce qu'**il comporte pour chaque fiche (11) une plaquette (13) selon l'une quelconque des revendications 1 à 6.

9. Adaptateur selon la revendication 8, **caractérisé en ce qu'**il comprend un support (31) non métallique, de préférence en plastique, réalisé en un matériau susceptible de résister sans déformation à la température d'un four de refusion.

10. Adaptateur selon la revendication 9, **caractérisé en ce que** le support (31) non métallique est apte à résister à des températures inférieures à 300 DEG C.

11. Adaptateur selon la revendication 10, **caractérisé en ce que** le support (31) non métallique est apte à résister à des températures inférieures à 250 DEG C.

12. Adaptateur selon l'une quelconque des revendications 9 à 11, **caractérisé en ce que** le support (31) non métallique est réalisé en PCT, SPS ou un polymère cristallin.

13. Adaptateur selon l'une des revendications 9 à 12, **caractérisé en ce que** le support (31) non métallique présente des premiers (33) moyens de positionnement, par exemple des trous, aptes à coopérer avec des moyens complémentaires de la carte à circuit imprimé pour un positionnement exact de l'adaptateur sur la carte à circuit imprimé (7) avant refusion.

14. Adaptateur selon l'une des revendications 9 à 13, **caractérisé en ce que** le support (31) non métallique présente des seconds (35) moyens de positionnement, par exemple une découpe, aptes à coopérer avec des moyens complémentaires du composant électrique (9) pour un positionnement exact du composant sur l'adaptateur après refusion.

15. Adaptateur selon l'une quelconque des revendications 8 à 14, **caractérisé en ce que** les plaquettes (13) sont reliées par un pont sécable (37) avant installation sur le circuit imprimé et surmoulés lors de la fabrication du support (31).

## Claims

1. Metal connection plate (13) for establishing an electrical connection between an electrical component (9) and a printed circuit board (7), in which the component (9) comprises at least one connection plug (11) intended to be connected to said printed circuit board (7), **characterized in that** said plate (13) has a generally planar shape with, at one end, a reflow connection pad (15) intended to be connected by reflow to a contact joined to the printed circuit board (7) and, at the other end, a crimp-on electrical contact (25) intended to receive said connection plug (11) so as to establish, by insertion of the plug (11), a contact with the electrical component (9), said crimp-on electric contact (25) having two lateral ribs (27) and a central tongue (29) produced by punching and placed facing each other.

2. Plate according to Claim 1, **characterized in that** the reflow connection pad (15) has a projection (17) intended to make contact with the printed circuit (7) and the solder paste.

3. Plate according to Claim 2, **characterized in that** the projection (17) has a planar central part (19).

4. Plate according to one of Claims 1 to 3, **characterized in that** voids (21) are left around each connection pad (15) to absorb surplus braze so as to favour the formation of the solder meniscus.

5. Plate according to one of Claims 1 to 4, **characterized in that** the central tongue (29) is longer than the lateral ribs (27) and is inclined towards the ribs (27) so as to ensure a mechanical crimp of the plug (11) of the electrical component (9).

6. Plate according to one of Claims 1 to 5, **characterized in that** at least one of the lateral ribs (27) has a sufficient length to make contact with the printed circuit (7) and the solder paste.

7. Electrical component comprising at least one connection plug (11) intended to be connected to said printed circuit board (7), **characterized in that** it comprises, for each plug (11), a plate (13) according to any one of Claims 1 to 6 integrated by overmoulding of its surface intended to be facing a printed circuit board.

8. Connection adaptor for establishing an electrical connection between an electrical component (9) and a printed circuit board (7), in which the component (9) comprises at least one connection plug (11) intended to be connected to said printed circuit board (7), **characterized in that** it comprises, for each plug (11), a plate (13) according to any one of Claims 1 to 6.

9. Adaptor according to Claim 8, **characterized in that** it comprises a non-metallic, preferably plastic, support (31) produced from a material able to withstand the temperature of a reflow oven without deforming.

10. Adaptor according to Claim 9, **characterized in that** the non-metallic support (31) is able to withstand temperatures of less than 300°C.

11. Adaptor according to Claim 10, **characterized in that** the non-metallic support (31) is able to withstand temperatures of less than 250°C.

12. Adaptor according to any one of Claims 9 to 11, **characterized in that** the non-metallic support (31) is produced from PCT, SPS or a crystalline polymer.

13. Adaptor according to one of Claims 9 to 12, **characterized in that** the non-metallic support (31) has first positioning means (33), for example holes, suitable for cooperating with complementary means of the printed circuit board for precise positioning of the adaptor on the printed circuit board (7) before reflow.

14. Adaptor according to one of Claims 9 to 13, **characterized in that** the non-metallic support (31) has second positioning means (35), for example a cut-out, suitable for cooperating with complementary means of the electrical component (9) for precise positioning of the component on the adaptor after reflow.

15. Adaptor according to any one of Claims 8 to 14, **characterized in that** the plates (13) are connected by a divisible bridge (37) before installation on the printed circuit and overmoulded during the fabrication of the support (31).

## Patentansprüche

1. Metallisches Verbindungsplättchen (13), das es ermöglicht, eine elektrische Verbindung zwischen einem elektrischen Bauteil (9) und einer gedruckten Leiterplatte (7) herzustellen, wobei das Bauteil (9) mindestens einen Anschlussstecker (11) aufweist, der dazu bestimmt ist, mit der gedruckten Leiterplatte (7) verbunden zu werden, **dadurch gekennzeichnet, dass** das Plättchen (13) eine allgemein ebene Form besitzt, die einerseits einen Wiederaufschmelz-Verbindungsbereich (15), der dazu bestimmt ist, durch Wiederaufschmelzen mit einem zugeordneten Kontakt der gedruckten Leiterplatte (7) verbunden zu werden, und andererseits einen elektrischen Klemmkontakt (25) aufweist, der dazu bestimmt ist, den Anschlussstecker (11) aufzunehmen, um durch Einführen des Steckers (11) einen Kontakt mit dem elektrischen Bauteil (9) herzustellen, wobei der elektrische Klemmkontakt (25) zwei seitliche Flügel (27) und eine zentrale Zunge (29) aufweist, die durch Stanzen hergestellt werden und einander gegenüber angeordnet sind.

2. Plättchen nach Anspruch 1, **dadurch gekennzeichnet, dass** der Wiederaufschmelz-Verbindungsbereich (15) eine Wölbung (17) aufweist, die dazu bestimmt ist, mit der gedruckten Schaltung (7) und der Lötpaste in Kontakt zu sein.

3. Plättchen nach Anspruch 2, **dadurch gekennzeichnet, dass** die Wölbung (17) einen ebenen zentralen Bereich (19) aufweist.

4. Plättchen nach einem der Ansprüche 1 bis 3, **dadurch gekennzeichnet, dass** Materialaussparungen (21) um jeden Verbindungsbereich (15) herum zur Absorption des Lotüberschusses vorgesehen sind, um die Bildung der Lötkuppe zu begünstigen.

5. Plättchen nach einem der Ansprüche 1 bis 4, **dadurch gekennzeichnet, dass** die zentrale Zunge (29) eine größere Länge als diejenige der seitlichen Flügel (27) hat und in Richtung der Flügel (27) geneigt ist, um ein mechanisches Einklemmen des Steckers (11) des elektrischen Bauteils (9) zu gewährleisten.

6. Plättchen nach einem der Ansprüche 1 bis 5, **dadurch gekennzeichnet, dass** mindestens einer der seitlichen Flügel (27) eine ausreichende Länge aufweist, um mit der gedruckten Schaltung (7) und der Lötpaste in Kontakt zu kommen.

7. Elektrisches Bauteil, das mindestens einen Anschlussstecker (11) aufweist, der dazu bestimmt ist, mit der gedruckten Leiterplatte (7) verbunden zu werden, **dadurch gekennzeichnet, dass** es für jeden Stecker (11) ein Plättchen (13) nach einem der Ansprüche 1 bis 6 aufweist, das durch Überformen in seine Seite integriert ist, die dazu bestimmt ist, einer gedruckten Leiterplatte gegenüber zu liegen.

8. Verbindungsadapter, der es ermöglicht, eine elektrische Verbindung zwischen einem elektrischen Bauteil (9) und einer gedruckten Leiterplatte (7) herzustellen, bei dem das Bauteil (9) mindestens einen Anschlussstecker (11) aufweist, der dazu bestimmt ist, mit der gedruckten Leiterplatte (7) verbunden zu werden, **dadurch gekennzeichnet, dass** er für jeden Stecker (11) ein Plättchen (13) nach einem der Ansprüche 1 bis 6 aufweist.

9. Adapter nach Anspruch 8, **dadurch gekennzeichnet, dass** er einen nicht metallischen Träger (31), vorzugsweise aus Kunststoff, aufweist, der aus einem Werkstoff hergestellt ist, der ohne Verformung der Temperatur eines Wiederaufschmelzofens standhalten kann.

10. Adapter nach Anspruch 9, **dadurch gekennzeichnet, dass** der nicht metallische Träger (31) Temperaturen unter 300°C standhalten kann.

11. Adapter nach Anspruch 10, **dadurch gekennzeichnet, dass** der nicht metallische Träger (31) Temperaturen unter 250°C standhalten kann.

12. Adapter nach einem der Ansprüche 9 bis 11, **dadurch gekennzeichnet, dass** der nicht metallische Träger (31) aus PCT, SPS oder einem kristallinen Polymer hergestellt ist.

13. Adapter nach einem der Ansprüche 9 bis 12, **dadurch gekennzeichnet, dass** der nicht metallische Träger (31) erste Positioniereinrichtungen (33), zum Beispiel Löcher, aufweist, die mit komplementären Einrichtungen der gedruckten Leiterplatte für eine genaue Positionierung des Adapters auf der gedruckten Leiterplatte (7) vor dem Wiederaufschmelzen zusammenwirken können.

14. Adapter nach einem der Ansprüche 9 bis 13, **dadurch gekennzeichnet, dass** der nicht metallische Träger (31) zweite Positioniereinrichtungen (35), zum Beispiel einen Ausschnitt, aufweist, die mit komplementären Einrichtungen des elektrischen Bauteils (9) für eine genaue Positionierung des Bauteils auf dem Adapter nach dem Wiederaufschmelzen zusammenwirken können.

15. Adapter nach einem der Ansprüche 8 bis 14, **dadurch gekennzeichnet, dass** die Plättchen (13) vor dem Einbau auf der gedruckten Schaltung durch eine trennbare Brücke (37) verbunden sind und bei der Herstellung des Trägers (31) überformt werden.
